# EUROPEAN PATENT APPLICATION

(11) **EP 0 749 155 A2**
(43) Date of publication of application: **18.12.1996**
(21) Application number: 96304287.4
(22) Date of filing: 07.06.1996
(51) Int. Cl.: H01L 21/314, H01L 23/29, C04B 41/50

(54) **Composite electronic coatings**

(30) Priority: 16.06.1995 US 491071
(71) Applicant: DOW CORNING CORPORATION, Midland, Michigan 48686-0994 (US)
(72) Inventor: Haluska, Loren Andrew, Midland, Michigan 48640 (US); Michael, Keith Winton, Midland, Michigan 48640 (US)
(74) Representative: Lewin, John Harvey

(57) **Abstract**

The present invention provides a method of forming composite coatings on electronic substrates and the substrates coated thereby. The method comprises applying a coating comprising a polysilazane and a refractory fiber on an electronic substrate and then heating the coated substrate at a temperature sufficient to convert the polysilazane into a ceramic.

## Description

The present invention relates to composite coatings formed from polysilazanes and refractory fibers. These coatings are useful for forming coatings on electronic substrates.

The use of polysilazanes to form ceramic coatings on electronic devices is known in the art. For instance, WO 93/02472 discloses a process for forming a coating on an electronic substrate wherein a solution of a polysilazane resin is applied to an electronic substrate followed by heating the coated substrate in air at a temperature in the range of 150-800°C. This publication, however, does not describe the use of fillers within the coating.

Outside the field of protective coatings for electronic devices, the use of borosilazanes to form ceramic coatings is known in the art. For example, US-As 4,482,689 or 4,910,173 and European Publications 0 364 323 or 0 424 082 teach borosilazanes which are used to form such coatings. These documents, however, do not disclose the use of borosilazanes with fillers as coating compositions on electronics.

Similarly, the use of fillers within ceramic coatings derived from polysilazanes is known outside the field of protective coatings for electronic devices. For instance, JP-As 3-52287 and 1-221466 describe compositions comprising polysilazanes and fillers. These references, however, do not describe the use of such materials as protective coatings on the surface of electronic substrates.

In JP-A 32-50082, the incorporation of an electroconductive powder within a ceramic derived from a polysilazane is disclosed. This document, however, does not describe protective coatings on the surfaces of electronic substrates.

Similarly, ceramic composite coatings comprising ceramic fibers within ceramic matrices are also known in the art. The art, however, does not describe the use of polysilazane matrices containing fibers for forming coatings on electronic substrates.

We have now found that ceramic composite coatings containing refractory fibers can be formed on electronic devices for protection.

The present invention claims a method of forming a coating on an electronic substrate and the substrate coated thereby. The method comprises first applying a composition comprising a polysilazane and refractory fibers onto an electronic substrate. The coated substrate is then heated at a temperature sufficient to convert the polysilazane into a ceramic.

The present invention is based on our finding that ceramic composite coatings can be formed from compositions comprising polysilazanes and refractory fibers. These coatings are useful on electronic substrates because they provide excellent mechanical and dielectric protection. Additionally, the coatings are opaque such that visualization of the underlying device is impaired. Finally, the density variation between the fibers and the matrix makes it difficult to uniformly etch the coating and reveal the underlying substrate.

As used herein, the expression "ceramic matrix" is used to describe the hard coating obtained after heating the polysilazane. This coating contains both amorphous silica (SiO₂) materials as well as amorphous silica-like materials that may be not fully free of residual carbon (e.g., Si-C or Si-OC), silanol (Si-OH), nitrogen (Si-N), boron and/or hydrogen (which are obtained upon heating the polysilazane) and refractory fibers. The expression "electronic substrate" includes, but is not limited to, electronic devices or electronic circuits such as silicon based devices, gallium arsenide based devices, focal plane arrays, opto-electronic devices, photovoltaic cells and optical devices.

In our process, a ceramic coating is formed on a substrate by applying a coating composition comprising a polysilazane and refractory fibers onto the substrate and then heating the coated substrate at a temperature sufficient to convert the polysilazane to a ceramic.

The polysilazanes (or silazane polymers) useful in this invention are generally known in the art and their structure is not particularly critical. The polysilazanes of this invention generally contain units of the type [R₂SiNH], [RSi(NH)_{3/2}] and/or [R₃Si(NH)_{1/2}], wherein each R is independently selected from the group consisting of hydrogen atom, alkyl radicals containing 1 to 20 carbon atoms, aryl radicals and alkenyl radicals. Naturally, the polysilazanes useful in this invention may contain other silazane units. Examples of such units include [MeSi(NH)_{3/2}], [Me₂SiNH], [ViSi(NH)_{3/2}], [VI₂SINH], [PhMeSiNH], [PhViSiNH], [MeViSiNH], [HSi(NH)_{3/2}] and [H₂SiNH]. Mixtures of these polysilazanes may also be employed in the practice of this invention.

Our polysilazanes are prepared by techniques well known in the art. The actual method used to prepare a specific polysilazane is not critical. Suitable preceramic silazane polymers or polysilazanes are prepared by the methods of US-As 4,540,803 or 4,543,344. Other suitable polysilazanes can be prepared by the methods of US-As 4,312,970, 4,340,619, 4,395,460 and 4,404,153. Suitable polysilazanes also include those prepared by US-As 4,482,689 and 4,397,828. Still other suitable polysilazanes include those of EP-As 0 351 747 and 0 332 374 or those of US-As 4,543,344, 4,656,300, 4,689,252 and 5,030,744.

Especially preferred polysilazanes are those which have no carbon in the polymer repeating units since the resultant coatings have little carbon contamination. End blocking groups such as Me₃Si(NH)_{1/2} are acceptable in such polymers because they are generally removed during the subsequent pyrolysis steps.

The most preferred polymers used herein are those of US-As 4,340,619 and 4,540,803. The silazane polymers of the former patent are prepared by contacting and reacting in an inert, essentially anhydrous atmosphere a chlorine containing disilane or mixture of chlorine containing disilanes of the general formula (ClₓR_{y}Si)₂ with a disilazane having the general formula (R₃'Si)₂NH at a temperature in the range of 25°C. to 300°C. while distilling volatile byproducts, wherein R is vinyl, an alkyl group of 1-3 carbon atoms or a phenyl group; R' is vinyl, hydrogen atom, an alkyl group of 1-3 carbon atoms or a phenyl group; x has a value of 0.5-3; y has a value of 0-2.5 and the sum of x+y is 3. An especially preferred embodiment of the above process (US-A 4,340,619) involves the reaction of methylchlorodisilanes with hexamethyldisilazane to produce methylpolydisilylazane. The product silazane polymers may have a relatively high chloride ion content and it is preferred that such concentration be lowered before use in our claimed invention. A method for such removal is readily described in US-A 4,772,516 which comprises treating the polymer with ammonia for a time sufficient to remove the chlorine.

The silazane polymers of US-A 4,540,803 are prepared by a method which comprises contacting and reacting in an inert essentially anhydrous atmosphere, trichlorosilane with a disilazane at a temperature in the range of 25°C. to 300°C. while distilling volatile byproducts. The disilazane used in that process has the formula (R₃Si)₂NH where R is selected from the group consisting of vinyl, hydrogen atom, phenyl and alkyl radicals containing 1 to 3 carbon atoms. An especially preferred embodiment involves the reaction of trichlorosilane with hexamethyldisilazane to produce hydridopolysilazane.

In addition, polysilazanes doped with boron (i.e., polyborosilazanes or borosilazanes) are also within the scope of the present invention and are included in our definition of polysilazanes. These borosilazanes are generally well known in the art and their structure is not particularly critical. The boron content of these polymers is likewise generally not critical and can vary over a wide range (e.g., 0.1-50 wt %). Generally, the backbone of the borosilazanes of this invention contain Si-B, Si-N and B-N bonds with the remaining valences of these atoms filled by groups independently selected from the group consisting of hydrogen atom, alkyl radicals containing 1 to 20 carbon atoms such as methyl, ethyl and propyl, aryl radicals such as phenyl and alkenyl radicals such as vinyl. Preferred borosilazanes are those in which there is no carbon in the repeating units of the polymer, i.e., there may be carbon only in the polymeric endcaps.

Examples of specific borosilazanes include those described by Seyferth et al., J. Am. Ceram. Soc. 73, 2131-2133 (1990) or Noth, B. Anorg. Chem. Org. Chem., 16(9), 618-21, (1961); those described in US-As 4,910,173; 5,169,908; 4,482,689; 5,030,744 and 4,604,367; or those described in EP-As 0 364 323 and 0 424 082.

The methods for preparing such compounds are likewise known in the art and are described in the above references. Examples of such methods, however, comprise (1) reacting a boron trihalide with a silazane oligomer such as (RSi(NH)_{3/2})ₓ or ((CH₃)₃Si)₂NH, wherein R is selected from the group consisting of hydrogen atom, a hydrocarbon radical or a substituted hydrocarbon radical and x is an integer of 2-20; (2) reacting an organoborazine with an organopolysilane; and (3) the reaction of a boron compound such as a borane complex, boroxine, boron alkoxides and borazines with a polysilazane.

A particularly preferred polymer for use herein comprises the boron modified hydropolysilazane polymers of US-A 5,169,908. These polymers are produced by a process which comprises reacting a hydrosilazane polymer with a borane complex or diborane. In a more preferred embodiment of our invention, the hydropolysilazane used in the reaction of the above patent is produced by the reaction of trichlorosilane and hexamethyldisilazane as described in US-A 4,540,803.

Although only several polymers are described above, nearly any polysilazane or borosilazane may be used herein.

The refractory fibers used herein are known in the art and comprise any fiber which is compatible with the polysilazane and which can withstand sustained heating. Many of these fibers are commercially available. Examples of suitable fibers include those of silicon carbide, silicon nitride, silicon carbide deposited on a carbon core, aluminum borate, aluminum oxide, silicon oxide, silicon carbide containing titanium, silicon oxycarbides, silicon oxycarbonitrides, carbon, graphite, aramide and organics. These fibers may contain any desirable number of filaments per tow and have a length in the range of less than 1 micrometer (e.g., 0.1 micrometer) to 500 micrometers.

Examples of specific fibers include silicon carbide fibers with a diameter in the range of 10-20 micrometers manufactured by Nippon Carbon and sold under the trade name "Nicalon"™; fibers comprising silicon carbide deposited on a carbon core with a diameter of 143 micrometers manufactured by Avco and designated "SCS-6"; alumina-boric-silica fibers with a diameter of 10-12 micrometers manufactured by 3M and sold under the tradenames Nextel™ "312", "440" and "480"; Al₂O₃ fibers with a diameter of 20 micrometers manufactured by Du Pont™ under the designation "FP"; SiO₂ fibers with a diameter of 8-10 micrometers manufactured by J. P. Stevens™; Al₂O₃-SiO₂ fibers with a diameter in the range of 9-17 micrometers manufactured by Sumitomo™; silicon carbide fibers containing titanium with a diameter in the range of 8-10 micrometers manufactured by Ube™ and sold under the tradename "Tyranno"™; silicon carbide fiber with a diameter in the range of 6-10 micrometers manufactured by Avco; silicon oxycarbonitride fibers with a diameter in the range of 10-15 micrometers manufactured by Dow Corning™ designated "MPDZ" and "HPZ"; silicon carbide fibers with a diameter in the range of 10-15 micrometers manufactured by Dow Corning™ designated "MPS"; silicon nitride fibers such as those produced by Tonen™ or Rhone Poulenc™, Al₂O₃-ZrO₂ fibers with a diameter of 20 micrometers manufactured by Du Pont™ and designated "PRD-166", carbon fibers such as those sold by Hitco™ and aramide fibers sold under the tradename "KEVLAR"™ by DuPont™.

The refractory fibers used herein are chopped into short lengths for ease in coating. Any fiber length which can be manipulated into the desired coating is used herein. Generally, the lengths are less than 1 centimeter with lengths in the range of between 10 micrometers to 10 millimeters being preferred.

The amount of refractory fibers used in the present invention can also be varied over a wide range depending, for example, on the characteristics desired in the final coating. Generally, however, the refractory fibers are used in an amount less than 90 volume percent to insure that enough resin is present to bind the refractory fibers. Obviously, smaller amounts of fibers (e.g., 1-5 vol%) can also be used. Preferred are fiber volumes in the range of between 25 and 80%.

If desired, other materials may also be present in the coating composition. For instance, it is within the scope of the present invention to use a material which modifies the surface of the fiber for better adhesion or for better release. Typically, such agents are included in amounts from 0.1 to 5 wt%. Such materials can include, for example, silanes such as glycidoxypropyltrimethoxysilane, mercaptopropyltrimethoxysilane and vinyltriacetoxysilane. Similarly, it is within the scope of the invention to include suspending agents in the coating composition. These and other optional components are known to those skilled in the art.

According to our invention, the polysilazane, refractory fibers and any optional components are applied to the surface of an electronic substrate. The surface of the electronic substrate can be bare (i.e., no passivation) or the circuit can have a passivation. Such passivation can be, for example, ceramic coatings such as silica, silicon nitride, silicon carbide, silicon oxynitride and silicon oxycarbide, deposited by, for example, CVD, PVD or sol-gel procedures. Such passivation is known to those skilled in the art. Likewise, the circuit can be pre or post interconnected.

The coating composition can be applied in any manner, but a preferred method involves dissolving the polysilazane in a solvent and then dispersing the fiber and any optional components therein. This dispersion is next applied to the surface of an electronic substrate. Various facilitating measures such as stirring and/or heating may also be used to dissolve or disperse the polysilazane and fiber and to create a more uniform application material. Solvents which may be used include any agent or mixture of agents that will dissolve the polysilazane and disperse the fiber to form a uniform liquid mixture without affecting the resultant coating. These solvents can include, for example, aromatic hydrocarbons such as benzene or toluene; alkanes such as n-heptane or dodecane; ketones; alcohols; esters; ethers; and cyclic dimethylpolysiloxanes, in an amount sufficient to dissolve/disperse the above materials to the concentration desired for application. Generally, the solvent is used to form a 0.1-80 weight percent mixture, preferably 1-50 wt%.

If a liquid method is used, the liquid mixture comprising the polysilazane, refractory fiber, solvent and, any optional components is then coated onto the substrate. The method of coating can be, but is not limited to, spin coating, dip coating, spray coating or flow coating. Other equivalent means, however, are also deemed to be within the scope of this invention.

The solvent is then allowed to evaporate from the coated substrate resulting in the deposition of the polysilazane and refractory fiber coating. Any suitable means of evaporation may be used such as simple air drying by exposure to an ambient environment, by the application of a vacuum or mild heat (e.g., less than 50°C.) or during the early stages of the heat treatment. It is noted that when spin coating is used, the additional drying period is minimized as the spinning drives off the solvent.

Although the above methods primarily focus on using a liquid approach, one skilled in the art would recognize that other equivalent means such as melt deposition would also function herein.

The polysilazane is then typically converted to the ceramic by heating it to a sufficient temperature. Generally, the temperature is in the range of 50 to 1000°C. depending on the pyrolysis atmosphere. Preferred temperatures are in the range of 50 to 800°C., and more preferably 50-500°C. Heating is generally conducted for a time sufficient to ceramify, generally up to 6 hours, with less than 3 hours being preferred.

The above heating may be conducted at any effective atmospheric pressure from vacuum to superatmospheric and under any effective oxidizing or non-oxidizing gaseous environment such as air, O₂, an inert gas (N₂, Ar, etc.), ammonia, amines, moisture, N₂O and hydrogen.

Any method of heating such as the use of a convection oven, rapid thermal processing, hot plate or radiant or microwave energy is generally functional herein. The rate of heating, moreover, is also not critical, but it is most practical and preferred to heat as rapidly as possible.

By the above methods, a ceramic coating is produced on the substrate. The thickness of the coating can vary over a wide range (e.g., up to 500 micrometers). These coatings smooth the irregular surfaces of various substrates (i.e. planarizing), they are relatively defect free; they have excellent adhesive properties; they provide mechanical and electrical protection and they are opaque. Moreover, the fibers provide added strength and toughness to our coatings.

Additional coatings may be applied over these coatings if desired. These include, for example, SiO₂ coatings, SiO₂/ceramic oxide layers, silicon containing coatings, silicon carbon containing coatings, silicon nitrogen containing coatings, silicon oxygen nitrogen coatings, silicon nitrogen carbon containing coatings, organic coatings, silicone coatings and/or diamond like carbon coatings. Methods for the application of such coatings are known in the art and many are described in US-A 4,756,977. An especially preferred coating is silicon carbide applied by the chemical vapor deposition of silacyclobutane or trimethylsilane. This process is further described in US-A 5,011,706.

The following non-limiting examples are included so that one skilled in the art may more readily understand the invention.

### Example 1

Hydridopolysilazane resin, 2 g, produced by the method of US-A 4,540,803, 1 g of silicon carbide whiskers from Tateho Chemical Industries Co. Ltd. (0.5 x 15-20 micrometers), 0.4 g of glycidoxypropyltrimethoxysilane and 2.5 g of cyclic polydimethylsiloxanes were mixed with a sonic probe to form a coating solution. An 11.25 cm² alumina panel was coated with the solution by using a 75 micrometer drawdown bar. The coated panel was air dried for 3 hours and then pyrolyzed for 2 hours at 400°C. in air. The pyrolyzed coating was examined with a microscope and found to have no cracks at 1000x magnification. The coating thickness was 22.3 micrometers.

### Example 2

Borohydridopolysilazane resin, 2 g, produced by the method of US-A 5,169,908, 1 g of the above silicon carbide whiskers, 0.4 g of glycidoxypropyltrimethoxysilane and 2.0 g of cyclic polydimethylsiloxanes were mixed with a sonic probe to form a coating solution. A similar alumina panel was coated with the solution by using the same drawdown bar. The coated panel was air dried for 3.5 hours and pyrolyzed for 1 hour at 400°C. in air. The pyrolyzed coating was examined with a microscope and also found to have no cracks at 1000x magnification. The coating thickness was 18.2 micrometers.

## Claims

1. A method of forming a composite coating on an electronic substrate comprising applying a coating composition comprising a polysilazane and refractory fibers onto the electronic substrate and heating the coated electronic substrate at a temperature sufficient to convert the polysilazane into a ceramic.

2. The method of claim 1 wherein the refractory fiber is selected from the group consisting of carbon, silicon carbide, silicon nitride, aluminum oxide, organic fiber and aramide fiber.

3. The method of claim 1 or 2 wherein the coated substrate is heated at a temperature in the range of between 50°C, and 1000°C, for less than 6 hours.

4. The method of any of claims 1 to 3 wherein the coating composition also contains a material which modifies the surface of the refractory fiber for better adhesion of the ceramic.

5. The method of any of claims 1 to 4 wherein the coating composition also contains an amount of an agent effective to improve the suspension of the fiber in the coating composition.

6. The method of any of claims 1 to 5 wherein the fiber is present in the coating composition in an amount less than 90 volume percent.

7. The method of any of claims 1 to 6 wherein the polysilazane is selected from the group consisting of hydridopolysilazane, methylpolydisilylazane and polyborosilazane.
